(19) Europäisches Patentamt

European Patent Office

Office européen des brevets

(11) EP 0 966 050 A2

(12) **EUROPÄISCHE PATENTANMELDUNG**

(43) Veröffentlichungstag:
22.12.1999 Patentblatt 1999/51

(51) Int. Cl.$^6$: **H01L 51/20**

(21) Anmeldenummer: 99110877.0

(22) Anmeldetag: 07.06.1999

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **18.06.1998 DE 19827222**

(71) Anmelder:
**SIEMENS AKTIENGESELLSCHAFT**
**80333 München (DE)**

(72) Erfinder:
• **Böhler, Achim Dipl.-Phys.**
**63743 Aschaffenburg (DE)**
• **Wiese, Stefan Dipl.-Ing.**
**38114 Braunschweig (DE)**
• **Metzdorf, Dirk**
**38104 Braunschweig (DE)**
• **Kowalsky, Wolfgang Dr.**
**38116 Braunschweig (DE)**

(54) **Organische Leuchtdiode**

(57)    Die organische Leuchtdiode nach der Erfindung weist folgende Bestandteile auf:

- eine auf einem Substrat befindliche transparente Bottom-Elektrode,
- eine Top-Elektrode,
- wenigstens eine zwischen Bottom-Elektrode und Top-Elektrode angeordnete organische Funktionsschicht und
- eine auf der Bottom-Elektrode befindliche semitransparente Schicht aus einem Metall mit einer Austrittsarbeit zwischen 4 und 7 eV.

## Beschreibung

Die Erfindung betrifft eine organische Leuchtdiode, d.h. eine Licht-emittierende Diode auf Polymerbasis.

Mit dem zunehmenden Austausch von Daten und Information gewinnt deren Visualisierung, vorzugsweise in Endgeräten der Kommunikationstechnik, immer mehr an Bedeutung. Diese Informationsdarstellung findet üblicherweise mittels Pixel-Matrix-Anzeigevorrichtungen statt, die gegebenenfalls zusätzliche, fest vorgegebene Symboldarstellungen („Icons") aufweisen. Bekannte Technologien von Pixel-Matrix-Vorrichtungen sind beispielsweise Kathodenstrahlbildröhren, die allerdings wegen des Platzbedarfs, der elektrischen Leistungsaufnahme und des Gewichts nicht für den Einsatz in mobilen und tragbaren elektronischen Geräten in Frage kommen. Wesentlich besser geeignet sind für diesen Zweck Flachbildschirme („Flat Panel Displays"), die heutzutage vorwiegend auf der Technologie der Flüssigkristall-Displays (LC-Displays) basieren.

Einfache, monochrome, passiv-matrix-getriebene LC-Displays bieten den Vorteil einer kostengünstigen Herstellbarkeit neben geringer elektrischer Leistungsaufnahme, kleinem Gewicht und geringem Platzbedarf. Jedoch sind mit dem Einsatz derartiger Displays auch gravierende Nachteile verbunden. Aufgrund des technologisch-physikalischen Prinzips sind die Anzeigen nämlich nicht selbst-emittierend, d.h. sie sind nur unter besonders günstigen Umgebungslichtverhältnissen zuverlässig abzulesen und zu erkennen. Eine weitere wesentliche Beschränkung besteht in dem stark eingeschränkten Betrachtungswinkel der Anzeige.

Das Problem des mangelnden Kontrastes bei nicht optimalen Umgebungslichtverhältnissen läßt sich zwar durch eine zusätzlich angebrachte Hinterleuchtung verbessern, allerdings ist diese Verbesserung mit mehreren Nachteilen verbunden. So wird durch die Hinterleuchtung die Dicke des LC-Flachbildschirms vervielfacht. Während nämlich LC-Displays ohne Hinterleuchtung mit einer Dicke < 1 mm gefertigt werden können, beträgt die Gesamtdicke von hinterleuchteten LC-Displays typischerweise einige Millimeter. Neben den Lampen bzw. Leuchtstoffröhren trägt vor allem die zur homogenen Ausleuchtung der Displayfläche notwendige Lichtleitplastik („Diffusor") zur Vergrößerung der Dicke bei. Ein wesentlicher Nachteil der Hinterleuchtung besteht außerdem darin, daß der überwiegende Anteil der elektrischen Leistungsaufnahme für die Beleuchtung benötigt wird. Darüber hinaus wird zum Betrieb der Lichtquellen (Lampen und Leuchtstoffröhren) eine höhere Spannung benötigt, die üblicherweise mit Hilfe von „Voltage-up-Convertern" aus Batterien oder Akkumulatoren erzeugt wird.

Eine bessere Performance als mit im Passiv-Modus angesteuerten LC-Displays kann mit Aktiv-Matrix-LC-Displays erreicht werden. Dabei ist jedem Bildpunkt mit seinen drei Grundfarben jeweils ein Dünnfilmtransistor (Thin Film Transistor, TFT) zugeordnet. Die TFT-Technologie ist jedoch sehr aufwendig, und aufgrund der hohen auftretenden Prozeßtemperaturen werden hohe Anforderungen an die verwendeten Substrate gestellt; dementsprechend hoch ist der Preis für Aktiv-Matrix-LC-Displays.

Die Schaltzeit eines einzelnen Flüssigkristall-Pixels beträgt - bedingt durch das physikalische Prinzip der Re-Orientierung eines Moleküls im elektrischen Feld - typischerweise einige Millisekunden und ist zudem noch stark temperaturabhängig. So macht sich bei tiefen Temperaturen der langsame und verzögerte Bildaufbau, beispielsweise in Verkehrsmitteln (Navigationssysteme in Kraftfahrzeugen), störend bemerkbar. Für Applikationen, in denen rasch wechselnde Informationen bzw. Bilder zur Anzeige kommen, beispielsweise bei Videoapplikationen, ist die LC-Technologie deshalb nur bedingt einsetzbar.

Andere Display-Technologien haben entweder noch nicht den Reifegrad einer technischen Anwendbarkeit erreicht, beispielsweise Flat-Panel-CRTs (CRT = Cathode Ray Tube), oder ihrem Einsatz, vor allem in tragbaren elektronischen Geräten, stehen gravierende Nachteile aufgrund spezifischer Kenngrößen gegenüber: hohe Betriebsspannung bei Vakuum-Fluoreszenz-Anzeigen und anorganischen Dünnfilm-Elektrolumineszenz-Anzeigen bzw. hohe Kosten bei Displays auf der Basis anorganischer Leuchtdioden.

Die genannten Nachteile lassen sich mit Anzeigen auf der Basis von organischen Leuchtdioden (Organic Light Emitting Diodes, OLEDs), d.h. elektrolumineszierenden Dioden, umgehen (siehe dazu beispielsweise US-PS 4 356 429 und US-PS 5 247 190). Diese neue Technologie weist gegenüber LC-Displays vielfältige Vorteile auf, von denen die wesentlichen folgende sind:

-  Aufgrund des Prinzips der Selbstemissivität entfällt die Notwendigkeit einer Hinterleuchtung, was Platzbedarf, Leistungsaufnahme und Gewicht deutlich reduziert.
-  Die typischen Schaltzeiten von Bildelementen liegen in der Größenordnung von 1 $\mu$s und erlauben damit problemlos die Darstellung schneller Bildfolgen.
-  Die Schaltzeiten weisen keine störende Trägheit bei niedrigen Temperaturen auf.
-  Der Ablesewinkel ist wesentlich größer als bei LC-Displays und beträgt nahezu 180°.
-  Die bei LC-Displays notwendigen Polarisatoren entfallen, so daß eine größere Helligkeit auch bei gemultiplexter Anzeige erreichbar ist.
-  Organische Leuchtdioden lassen sich im Gegensatz zu anderen Display-Technologien auch auf flexiblen Substraten und in nicht-planaren Geometrien herstellen.

Die Herstellung und der Aufbau von Displays auf der Basis organischer Leuchtdioden ist im Vergleich zu LC-Displays einfacher und damit kostengünstiger realisierbar. Typischerweise erfolgen Aufbau und Herstellung folgendermaßen.

Das Substrat, beispielsweise Glas, ist ganzflächig mit einer transparenten Elektrode (Bottom-Elektrode, Anode), beispielsweise aus Indium-Zinn-Oxid (ITO), beschichtet. Zur Herstellung von Pixel-Matrix-Anzeigen muß sowohl die transparente Bottom-Elektrode als auch die Top-Elektrode (Kathode) strukturiert werden. Beide Elektroden sind dabei üblicherweise in Form von parallelen Leiterbahnen strukturiert, wobei die Leiterbahnen von Bottom-Elektrode und Top-Elektrode senkrecht zueinander verlaufen. Die Strukturierung der Bottom-Elektrode erfolgt mit einem photolithographischen Prozeß unter Einschluß naßchemischer Ätzverfahren, deren Details dem Fachmann bekannt sind. Die Auflösung, die mit diesen Verfahren erreichbar ist, wird im wesentlichen durch die photolithographischen Schritte und die Beschaffenheit der Bottom-Elektrode begrenzt. Nach dem Stand der Technik sind dabei sowohl Pixelgrößen wie auch nicht emittierende Zwischenräume zwischen den Pixeln von wenigen Mikrometern Größe realisierbar. Die Länge der streifenförmigen Leiterbahnen der Bottom-Elektrode kann bis zu vielen Zentimetern betragen. Je nach verwendeter Lithographiemaske können auch emittierende Flächen bis zu einer Größe von mehreren Quadratzentimetern erzeugt werden. Die Abfolge der einzelnen emittierenden Flächen kann regelmäßig (Pixel-Matrix-Display) oder variabel sein (Symboldarstellungen).

Auf das Substrat mit der strukturierten transparenten Bottom-Elektrode werden eine oder mehrere organische Schichten aufgebracht. Diese organischen Schichten können aus Polymeren, Oligomeren, niedermolekularen Verbindungen oder Mischungen hiervon bestehen. Zum Aufbringen von Polymeren, beispielsweise Polyanilin, Poly(p-phenylen-vinylen) und Poly(2-methoxy-5-(2'-ethyl)-hexyloxy-p-phenylen-vinylen), finden üblicherweise Prozesse aus flüssiger Phase Anwendung (Auftragen einer Lösung mittels Spin-Coating oder Rakeln), während für niedermolekulare und oligomere Verbindungen eine Gasphasenabscheidung bevorzugt wird (Aufdampfen oder „Physical Vapor Deposition", PVD). Beispiele für niedermolekulare, bevorzugt positive Ladungsträger transportierende Verbindungen sind: N,N'-Bis-(3-methylphenyl)-N,N'-bis-(phenyl)-benzidin (m-TPD), 4,4',4"-Tris-(N-3-methylphenyl-N-phenyl-amino)-triphenylamin (m-MTDATA) und 4,4',4"-Tris-(carbazol-9-yl)-triphenylamin (TCTA). Als Emitter wird beispielsweise Hydroxychinolin-Aluminium-III-Salz (Alq) verwendet, das mit geeigneten Chromophoren dotiert sein kann (Chinacridon-Derivate, aromatische Kohlenwasserstoffe u.s.w.). Gegebenenfalls können zusätzliche, die elektrooptischen Eigenschaften ebenso wie die Langzeiteigenschaften beeinflussende Schichten vorhanden sein, beispielsweise aus Kupfer-Phthalocyanin. Die gesamte Dicke der Schichtabfolge kann zwischen 10 nm und 10 µm betragen, typischerweise liegt sie im Bereich zwischen 50 und 200 nm.

Die Top-Elektrode besteht üblicherweise aus einem Metall, das im allgemeinen durch Gasphasenabscheidung aufgebracht wird (thermisches Verdampfen, Sputtern oder Elektronenstrahlverdampfung). Bevorzugt werden unedle und damit insbesondere gegenüber Wasser und Sauerstoff reaktive Metalle eingesetzt, wie Lithium, Magnesium, Aluminium und Calcium sowie Legierungen dieser Metalle untereinander oder mit anderen Metallen. Die zur Herstellung einer Pixel-Matrix-Anordnung erforderliche Strukturierung der Metallelektrode wird im allgemeinen dadurch erreicht, daß das Metall durch eine Schattenmaske hindurch aufgebracht wird, die entsprechend geformte Öffnungen aufweist.

Ein in dieser Weise hergestelltes OLED-Display kann zusätzliche, die elektrooptischen Eigenschaften beeinflussende Einrichtungen enthalten, wie UV-Filter, Polarisationsfilter, Anti-Reflex-Beschichtungen, als „Micro-Cavities" bekannte Einrichtungen sowie Farbkonversions- und Farbkorrekturfilter. Ferner ist eine hermetische Verpackung („Packaging") vorhanden, durch das die organischen elektrolumineszierenden Displays vor Umwelteinflüssen, wie Feuchtigkeit und mechanische Belastungen, geschützt werden. Außerdem können Dünnfilmtransistoren zur Ansteuerung der einzelnen Bildelemente („Pixel") vorhanden sein.

Speziell für mobile Anwendungen, wie bei Handys, Pager und Personal Digital Assistants (PDA), mit Batteriebetrieb sind Displays mit möglichst niedriger Betriebsspannung wünschenswert. Hierbei ist neben der für die Erzeugung des Lichts erforderlichen Mindestspannung ($U = h \cdot c/e \cdot \lambda$, mit h = Planck-Konstante, c = Lichtgeschwindigkeit, e = Elektronenladung und $\lambda$ = Wellenlänge des erzeugten Lichts) noch ein wesentlicher Spannungsanteil für die Überwindung intrinsischer Barrieren erforderlich, die zwischen den verschiedenen Schichten entstehen.

Durch eine geeignete Auswahl von Anoden- und Kathodenmaterial kann im Prinzip eine effiziente Injektion der Ladungsträger ins Bauelement und damit eine kleine Betriebsspannung erreicht werden. Abhängig von den verwendeten organischen Materialien sollte dabei - zur Realisierung von ohmschen Kontakten - die Austrittsarbeit der Anode im Bereich von 5 bis 5,5 eV liegen. Da, wie bereits ausgeführt, zur Auskoppelung des Lichts aus dem Bauelement eine Elektrode transparent gewählt wird, wobei typischerweise ITO mit einer Austrittsarbeit von ca. 4,9 eV als Anodenmaterial zum Einsatz gelangt, wurde versucht, entweder durch Nachoxidieren von ITO oder durch den Einsatz anderer transparenter oxidischer Substanzen, wie Vanadiumoxid, die Austrittsarbeit der Anode zu erhöhen und damit die ausgebildete Energiebarriere an der Grenzfläche Anode/organisches Material zu reduzieren. Dies führt zwar zu einer niedrigeren Betriebsspannung der Leuchtdioden, allerdings sind die verwendeten Anodenmaterialien nicht langzeitstabil oder weisen andere Nachteile auf, wie höhere Herstellungskosten.

Aufgabe der Erfindung ist es, organische Leuchtdioden derart auszugestalten, daß sie eine möglichst niedrige Betriebsspannung aufweisen und deshalb insbesondere im Bereich der mobilen Kommunikation, d.h. in Geräten mit Batteriebetrieb, eingesetzt werden können. Dabei dürfen aber die übrigen Systemparameter nicht nachteilig beeinflußt werden, d.h. beispielsweise darf der Strombedarf nicht zu hoch sein und die Langzeitstabilität muß gewährleistet sein.

Dies wird erfindungsgemäß dadurch erreicht, daß die Leuchtdioden folgende Bestandteile aufweisen:

- eine auf einem Substrat befindliche transparente Bottom-Elektrode,
- eine Top-Elektrode,
- wenigstens eine zwischen Bottom-Elektrode und Top-Elektrode angeordnete organische Funktionsschicht und
- eine auf der Bottom-Elektrode befindliche semitransparente Schicht aus einem Metall mit einer Austrittsarbeit zwischen 4 und 7 eV.

Das wesentliche Merkmal einer Leuchtdiode nach der Erfindung ist somit die auf der transparenten Bottom-Elektrode (Anode), d.h. zwischen Anode und organischer Funktionsschicht angeordnete dünne, semitransparente Metallschicht. Der Begriff „semitransparent" bedeutet hierbei, daß etwa 10 bis 95 % des Lichts im sichtbaren Spektralbereich durch die Schicht hindurchtreten.

Die Metallschicht, die vorzugsweise eine Dicke von 1 bis 100 nm besitzt, dient als Injektionsschicht für die Ladungsträger in das organische Material, im vorliegenden Fall somit als Löcher-injizierende Schicht. Das Metall ist inert und somit langzeitstabil, und die Metallschicht weist eine ausreichende Transparenz auf. Da das Metall eine Austrittsarbeit im Bereich von 4 bis 7 eV besitzt, wird die Ausbildung einer Energiebarriere an der Grenzfläche Anode/organisches Material verhindert und damit die Betriebsspannung der Leuchtdioden drastisch gesenkt.

Die Metallschicht besteht vorzugsweise aus einem Edelmetall, insbesondere aus Palladium, Silber, Iridium, Platin oder Gold. Weitere geeignete Metalle sind beispielsweise Chrom, Eisen, Cobalt, Nickel, Molybdän und Wolfram. Das besonders bevorzugte Platin beispielsweise hat eine Austrittsarbeit von 5,7 eV.

Als Material für die organische(n) Funktionsschicht(en) dienen an sich bekannte Verbindungen. Dies sind beispielsweise Polymere, wie Polyanilin, Poly(p-phenylen-vinylen) und Poly(2-methoxy-5-(2'-ethyl)-hexyloxy-p-phenylen-vinylen), oder niedermolekulare Verbindungen, wie 4,4',4''-Tris-(N-3-methylphenyl-N-phenyl-amino)-triphenylamin (m-MTDATA) und 4,4',4''-Tris(carbazol-9-yl)-triphenylamin (TCTA). Vorzugsweise werden folgende Verbindungen verwendet: N,N'-Bis-(3-methylphenyl)-N,N'-bis(phenyl)-benzidin(m-TPD) und 1,3,5-Tris[N-(4-diphenylamino-phenyl)-phenylamino]-benzol (p-DPATDAB). In Kombination mit einem organischen Material kann auch Kupferphthalocyanin Verwendung finden. Besonders vorteilhaft wird für den Transport der positiven Ladungsträger 4,4',4''-Tris[N-(1-naphthyl)-N-phenyl-amino]-triphenylamin zusammen mit Hydroxychinolin-Aluminium-III-Salz als Emissions- und Elektronentransportmaterial eingesetzt.

Die Bottom-Elektrode (Anode) und die Top-Elektrode (Kathode) können aus an sich bekannten Materialien bestehen. Die Bottom-Elektrode besteht dabei vorzugsweise aus Indium-Zinn-Oxid (ITO) und die Top-Elektrode vorzugsweise aus Magnesium, Aluminium, Calcium, Barium, Samarium oder Ytterbium, insbesondere aus Magnesium und Silber bzw. aus einer Magnesium-Silber-Legierung.

Anhand von Ausführungsbeispielen soll die Erfindung noch näher erläutert werden.

Beispiel 1

Ein Glassubstrat wird ganzflächig mit Indium-Zinn-Oxid (ITO) als leitfähige, transparente Elektrode (Anode) beschichtet, die anschließend in an sich bekannter Weise photolithographisch strukturiert wird. Auf die ITO-Schicht wird dann mittels Elektronenstrahlverdampfen eine 5nm dicke semitransparente Metall-Injektionsschicht aus Platin (Pt) aufgebracht; der Prozeßdruck beträgt hierbei $10^{-6}$ mbar. Die Pt-Injektionsschicht wird anschließend - je nach Anwendung - in an sich bekannter Weise photolithographisch strukturiert. Mittels organischer Molekularstrahldeposition (Organic Molecular Beam Deposition, OMBD) werden nachfolgend bei einem Prozeßvakuum von $10^{-8}$ mbar nacheinander die niedermolekulare Verbindung 4,4',4''-Tris[N-(1-naphthyl)-N-phenyl-amino]-triphenylamin (TNATA) für den Transport positiver Ladungsträger und Hydroxychinolin-Aluminium-III-Salz als Emissions- und Elektronentransportmaterial abgeschieden. Die Schichtdicken der Materialien betragen hierbei jeweils 60 nm; die Wachstumsraten liegen bei 2 nm/min.

Auf das auf diese Weise erhaltene Bauteil wird mittels einer Schattenmaske eine Kathode aufgebracht. Sie besteht aus einer 120 nm dicken Magnesiumschicht und einer 120 nm dicken Silberschicht, die nacheinander durch thermisches Verdampfen (aus Wolfram-Schiffchen) bei einem Prozeßdruck von $10^{-6}$ mbar abgeschieden werden. Die so definierten Kontaktflächen der LEDs sind rund und haben einen Durchmesser von 1,5 mm; der Abstand benachbarter Bauelemente beträgt 4,5 mm. Die Emissionfarbe ist grünlich-gelb und deutlich sichtbar, auch bei hellem Tageslicht unter Sonneneinstrahlung.

Beispiel 2

Auf ein entsprechend Beispiel 1 hergestelltes Bauteil wird eine Kathode aufgebracht, die aus einer 100 nm dicken Schicht aus einer Magnesium-Silber-Legierung besteht. Diese Schicht wird durch gleichzeitiges thermisches Verdampfen von Magnesium und Silber (aus zwei Wolfram-Schiffchen) in einem Atommassenverhältnis von 10:1 bei einem Prozeßdruck von $10^{-6}$ mbar abgeschieden. Zur Stabilisierung des Kontaktes dient eine 100 nm dicke Silberschicht. Die so definierten Kontaktflächen der LEDs sind rund und haben einen Durchmesser von 1,5 mm; der Abstand benachbarter Bauelemente beträgt 4,5 mm. Die Emissionfarbe ist grünlich-gelb und deutlich sichtbar, auch bei hellem Tageslicht unter Sonneneinstrahlung.

Beispiel 3

Entsprechend Beispiel 1 werden Leuchtdioden hergestellt, wobei die Pt-Injektionsschicht - anstatt Elektronenstrahlverdampfens - mittels eines thermischen Verdampfungsprozesses aufgebracht wird. Die Kontaktflächen der LEDs sind rund und haben einen Durchmesser von 1,5 mm; der Abstand benachbarter Bauelemente beträgt 4,5 mm. Die Emissionfarbe ist grünlichgelb und deutlich sichtbar, auch bei hellem Tageslicht unter Sonneneinstrahlung.

Beispiel 4

Entsprechend Beispiel 2 werden Leuchtdioden hergestellt, wobei die Pt-Injektionsschicht - anstatt Elektronenstrahlverdampfens - mittels eines thermischen Verdampfungsprozesses aufgebracht wird. Die Kontaktflächen der LEDs sind rund und haben einen Durchmesser von 1,5 mm; der Abstand benachbarter Bauelemente beträgt 4,5 mm. Die Emissionfarbe ist grünlichgelb und deutlich sichtbar, auch bei hellem Tageslicht unter Sonneneinstrahlung.

Beispiel 5

Entsprechend Beispiel 1 werden Leuchtdioden hergestellt, wobei die Pt-Injektionsschicht - anstatt Elektronenstrahlverdampfens - mittels eines Sputterprozesses aufgebracht wird. Die Kontaktflächen der LEDs sind rund und haben einen Durchmesser von 1,5 mm; der Abstand benachbarter Bauelemente beträgt 4,5 mm. Die Emissionfarbe ist grünlich-gelb und deutlich sichtbar, auch bei hellem Tageslicht unter Sonneneinstrahlung.

Beispiel 6

Entsprechend Beispiel 2 werden Leuchtdioden hergestellt, wobei die Pt-Injektionsschicht - anstatt Elektronenstrahlverdampfens - mittels eines Sputterprozesses aufgebracht wird. Die Kontaktflächen der LEDs sind rund und haben einen Durchmesser von 1,5 mm; der Abstand benachbarter Bauelemente beträgt 4,5 mm. Die Emissionfarbe ist grünlich-gelb und deutlich sichtbar, auch bei hellem Tageslicht unter Sonneneinstrahlung.

**Patentansprüche**

1. Organische Leuchtdiode, **gekennzeichnet** durch

   - eine auf einem Substrat befindliche transparente Bottom-Elektrode,
   - eine Top-Elektrode,
   - wenigstens eine zwischen Bottom-Elektrode und Top-Elektrode angeordnete organische Funktionsschicht und
   - eine auf der Bottom-Elektrode befindliche semitransparente Schicht aus einem Metall mit einer Austrittsarbeit zwischen 4 und 7 eV.

2. Organische Leuchtdiode nach Anspruch 1, **dadurch gekennzeichnet,** daß die Metallschicht eine Dicke von 1 bis 100 nm aufweist.

3. Organische Leuchtdiode nach Anspruch 1 oder 2, **dadurch gekennzeichnet,** daß die Metallschicht aus einem Edelmetall, insbesondere Platin, besteht.

4. Organische Leuchtdiode nach einem der Ansprüche 1 bis 3, **dadurch gekennzeichnet,** daß die Funktionsschicht aus 4,4',4"-Tris[N-(1-naphthyl)-N-phenylamino]-triphenylamin besteht.

5. Organische Leuchtdiode nach einem oder mehreren der Ansprüche 1 bis 4, **dadurch gekennzeichnet,** daß die Bottom-Elektrode aus Indium-Zinn-Oxid besteht.

6. Organische Leuchtdiode nach einem oder mehreren der Ansprüche 1 bis 5, **dadurch gekennzeichnet,** daß die Top-Elektrode aus Magnesium und Silber oder einer Magnesium-Silber-Legierung besteht.